# EUROPÄISCHE PATENTSCHRIFT

(11) **EP 3 988 892 B1**
(45) Veröffentlichungstag und Bekanntmachung des Hinweises auf die Patenterteilung: **18.09.2024**
(21) Anmeldenummer: 20202893.2
(22) Anmeldetag: 20.10.2020
(51) Int. Cl.: G01B 7/04, E03F 7/12, G01D 5/00

(54) **METERZÄHLER**
METER COUNTER
COMPTEUR DE LONGEUR

(43) Veröffentlichungstag der Anmeldung: 27.04.2022
(73) Patentinhaber: iPEK International GmbH, 87477 Sulzberg (DE)
(72) Erfinder: Wiese, Johannes, 87509 Immenstadt-Eckarts (DE)
(74) Vertreter: 2s-ip Schramm Schneider Bertagnoll Patent- und Rechtsanwälte Part mbB

(56) Entgegenhaltungen:
- DE-A1- 19 724 387
- FR-A2- 2 409 117
- US-A- 2 761 986
- US-A- 4 570 348
- US-A1- 2009 313 844
- US-B1- 10 527 402

## Beschreibung

### Gebiet der Erfindung

Die Erfindung betrifft eine Messvorrichtung zum Messen eines Vorschubs eines Kabels eines Kanalinspektions- und/oder Wartungssystems, sowie ein Verfahren zum Messen eines Vorschubs eines Kabels eines Kanalinspektions- und/oder Wartungssystems.

### Hintergrund der Erfindung

Kanalinspektions- und/oder Wartungssysteme werden in einen Kanal eingebracht und in dem Kanal vorgeschoben bzw. verfahren, um den Kanal zu inspizieren bzw. zu warten oder zu sanieren. Derartige Kanalinspektions- und/oder Wartungssysteme weisen üblicherweise Kabel bzw. Schiebeaale auf, mit welchen Sensoren und/oder Bildaufnahmeeinrichtungen in dem Kanal vorgeschoben werden können.

Üblicherweise wird das Kabel oder der Schiebeaal mittels einer Vortriebseinrichtung in den Kanal geschoben bzw. im Kanal vorgeschoben. Die Vortriebseinrichtung kann ein angetriebenes Rad oder ein angetriebener Riemen sein. Dabei berührt das Kabel das angetriebene Rad bzw. Riemen und wird aufgrund der Haftreibung zwischen der Oberfläche des Kabels und dem Rad bzw. Riemen vorgeschoben. Eine solche Vortriebseinrichtung kann beispielsweise an einem Fahrwagen angeordnet sein, der im Kanal verfahren wird, um ein Kabel oder einen Schiebeaal relativ zum Fahrwagen vorzuschieben bzw. zurückzuziehen. Eine solche Vortriebseinrichtung kann aber auch an einer Kabeltrommel angeordnet sein, die sich meist außerhalb des Kanalschachtes befindet, um das Kabel bzw. den Schiebeaal von der Kabeltrommel abzuwickeln bzw. auf die Kabeltrommel aufzuwickeln.

Im Idealfall wird das Kabel bzw. der Schiebeaal von der Vortriebseinrichtung fehler- und verschleißfrei befördert. Dieser Idealfall tritt in der Praxis allerdings nur selten auf.

In der Praxis können Schwierigkeiten beim Befördern des Kabels bzw. des Schiebeaals durch die Vortriebseinrichtung beispielsweise darin bestehen:
- Der Durchmesser des Kabels / des Schiebeaals ändert sich über seine Länge, etwa aufgrund von Quetschungen.
- Kabel / Schiebeaale unterschiedlichen Durchmessers sollen befördert werden.
- Das Kabel / der Schiebeaal soll so befördert werden, dass das Kabel / der Schiebeaal nicht beschädigt wird. Insbesondere soll eine möglichst verschleißfreie Beförderung des Kabels / des Schiebeaals gewährleistet werden.
- Während der Beförderung des Kabels / des Schiebeaals können sich die Reib- bzw. Hafteigenschaften des Kabels / des Schiebeaals ständig ändern. Die Reib- bzw. Hafteigenschaften hängen insbesondere von äußeren Umwelteinflüssen, etwa Verschmutzung ab. Die Reib- bzw. Hafteigenschaften können beispielsweise aber auch von der Steifigkeit und/oder von dem Mantelmaterial des Kabels / des Schiebeaals abhängen.

Die genannten Schwierigkeiten bringen in der Praxis meist folgende Nachteile mit sich:
- Zwischen dem Kabel / dem Schiebeaal und der Vortriebseinrichtung entsteht ein Schlupf, sodass das Kabel / der Schiebeaal nicht mehr oder nicht wie gewünscht befördert wird.
- Der Schlupf kann zu einem Verschleiß des Kabels / des Schiebeaals und/oder zu einem Verschleiß der Vortriebseinrichtung, insbesondere der Räder bzw. Riemen führen.

Der genannte Schlupf entsteht, wenn die für den effektiven Vorschub des Kabels / des Schiebeaals benötigte Haftreibung zwischen der Vortriebseinrichtung und dem Kabel / dem Schiebeaal nicht erreicht wird, sodass sich das Rad bzw. der Riemen dreht ohne das Kabel / den Schiebeaal weiter zu befördern. Daraus resultiert der weitere Nachteil, dass der konkrete Vorschub (d.h. die beförderte Länge in die eine und/oder in die andere Richtung) des Kabels / des Schiebeaals nicht mehr korrekt bestimmt werden kann. Die genaue Position beispielsweise des Kopfes eines Schiebeaals in dem Kanal kann so unter umständen nicht mehr bestimmt werden, was zur Folge haben kann, dass die genaue Position von Schadstellen im Kanal ebenfalls nicht mehr bestimmt werden kann.

Ein weiterer Nachteil des Schlupfes besteht darin, dass die beim Schlupf auftretende Gleitreibung zwischen der Vortriebseinrichtung und dem Kabel / dem Schiebeaal zu einer ungewollten Wärmeentwicklung führt. Dadurch kann sich einerseits das Kabel / der Schiebeaal, insbesondere der Mantel des Kabels / des Schiebeaals aufheizen, sodass Pausen eingelegt werden müssen, um das Kabel / den Schiebeaal wieder abzukühlen. Eine erwärmtes Kabels / erwärmter Schiebeaal kann zudem einem größeren Verschleiß unterliegen als ein nicht erwärmtes Kabels / erwärmter Schiebeaal. Andererseits kann sich dadurch auch die Vortriebseinrichtung, d.h. das Rad bzw. der Riemen stark erwärmen, was zu einem erheblichen und schnellen Verschleiß der Vortriebseinrichtung führen kann.

Das Problem der Erwärmung wirkt sich darüber hinaus insbesondere dann negativ aus, wenn beispielsweise ein Fahrwagen eines Kanalinspektions- und/oder Wartungssystems in einer explosionsgefährdeten Umgebung verwendet werden sollen, und an dem Fahrwagen die Vortriebseinrichtung angeordnet ist. Die Explosionsgefahr wird dann deutlich erhöht.

Aus der DE 197 24 387 A1 ist ein Wegsensor bekannt, bei dem ein absoluter Wert eines Bauteils, etwa ein Bremspedal, detektierbar ist. Eine Längsbewegung wird hierbei in eine Drehbewegung eines Sensorelements umgesetzt, das einen Magneten trägt.

Aus der US 2009/0313844 A1 ist eine Vorrichtung mit einem aufgewickelt Kabel bekannt, die ein Kabelmessmittel aufweist, um eine Länge des Kabels zu messen. Aus der US 10,527,402 B1 ist eine Vorrichtung bekannt, mit der auf magnetischer Basis die Länge eines von einer Kabeltrommel abgewickelten Kabels ermittelt werden kann. An dem drehbaren Teil der Trommel kann ein Magnet angeordnet werden, während an dem Rahmen der Trommel ein Magnetsensor angeordnet werden kann. Weitere Vorrichtungen, die zum Messen einer Länge Magnetfeldsensoren verwenden, sind aus den Dokumenten US 4,570,348 A, US 2,761,986 A und FR 2,409,117 A2 bekannt.

### Aufgabe der Erfindung

Aufgabe der vorliegenden Erfindung ist es daher, Lösungen bereitzustellen, die die aus dem Stand der Technik bekannten Nachteile zumindest teilweise vermeiden und mit denen die konkret beförderte Länge eines Kabels / eines Schiebeaals zuverlässiger ermittelt werden kann.

### Erfindungsgemäße Lösung

Erfindungsgemäß wird diese Aufgabe mit einer Vorrichtung und einem Verfahren nach den unabhängigen Ansprüchen gelöst. Vorteilhafte Ausgestaltungen und Weiterbildungen der Erfindung sind in den jeweiligen abhängigen Ansprüchen angegeben.

Bereit gestellt wird demnach eine Messvorrichtung zum Messen eines Vorschubs eines Kabels eines Kanalreinigungs- und/oder Kanalinspektionssystems, umfassend
- eine Ausgleichseinrichtung, umfassend
   - zumindest einen um eine Drehachse drehbar gelagerten Magneten, und
   - eine Magnetaufnahme zur Aufnahme des zumindest einen drehbar gelagerten Magneten, und
- einen Magnetfeldsensor,
wobei
- das Kabel beim Vorschub des Kabels an der Ausgleichseinrichtung vorbeiführbar ist,
- der zumindest eine drehbar gelagerte Magnet derart an der Magnetaufnahme angeordnet ist, dass durch den Vorschub des Kabels Drehungen des zumindest einen drehbar gelagerten Magneten um die Drehachse bewirkbar sind, wobei die Magnetaufnahme der Ausgleichseinrichtung angepasst ist, einer Bewegung des Kabels in radialer Richtung während des Vorschubs zu folgen, und
- der Magnetfeldsensor beabstandet zum zumindest einen drehbar gelagerten Magneten stationär angeordnet ist und angepasst ist, die Drehungen des zumindest einen drehbar gelagerten Magneten zu detektieren, wobei die detektierten Drehungen ein Maß für den Vorschub des Kabels sind.

Die Magnetaufnahme der Ausgleichseinrichtung ist angepasst, einer Bewegung des Kabels in radialer Richtung während des Vorschubs zu folgen, um zu gewährleisten, dass auch bei einer radialen Bewegung des Kabels während des Vorschubs die Drehung des Magneten bewirkt wird. eine Bewegung des Kabels in radialer Richtung kann etwa dann vorliegen, wenn sich das Kabel von der Ausgleichseinrichtung, an der das Kabel beim Vorschub vorbeigeführt wird, entfernt.

Die Ausgleichseinrichtung kann ein auf die Magnetaufnahme wirkendes Stellglied, insbesondere Federelement, umfassen, wobei das Stellglied ausgebildet ist,
- ein Schwenken der Magnetaufnahme um eine Schwenkachse oder
- ein lineares Verschieben der Magnetaufnahme
zu bewirken, wodurch die Magnetaufnahme der radialen Bewegung des Kabels folgt.

Die Magnetaufnahme umfasst einen Schwenkarm, und der zumindest eine drehbar gelagerte Magnet kann vorzugsweise an einem freien Ende des Schwenkarms angeordnet sein. "An einem freien Ende" bedeutet im Sinne der Erfindung, dass der Magnet im Bereich des freien Endes bzw. in der Nähe des freien Endes angeordnet sein kann.

Vorteilhaft ist es, wenn das Stellglied derart relativ zur Magnetaufnahme angeordnet ist, dass eine Beaufschlagung der Magnetaufnahme mit einer Stellkraft des Stellgliedes den zumindest einen an der Magnetaufnahme drehbar gelagerten Magneten an das vorbeigeführte Kabel drückt. Das Stellglied kann in einer Ausgestaltung der Erfindung in bzw. an der Schwenkachse angeordnet sein.

Der zumindest eine drehbar gelagerte Magnet kann in einem Gehäuse angeordnet sein, wobei das Gehäuse vorzugsweise eine drehsymmetrische Form, insbesondere zylindrische Form, aufweist.

In einer Ausgestaltung der Erfindung kann das Gehäuse eine raue Oberfläche aufweisen. Je nach Material des Kabelmantels kann so die Haftreibung zwischen Gehäuse und Kabeloberfläche verbessert werden.

In einer Ausgestaltung der Erfindung kann die Schwenkachse die Drehachse des zumindest einen drehbar gelagerten Magneten bilden.

In einer Ausgestaltung der Erfindung kann die Messvorrichtung ein drehbar gelagertes Element umfassen, das derart an der Magnetaufnahme angeordnet ist, dass durch den Vorschub des Kabels Drehungen des drehbar gelagerten Elements bewirkbar sind, wobei
- das drehbar gelagerte Element mit dem zumindest einen drehbar gelagerten Magneten koppelbar ist, und
- die Drehungen des drehbar gelagerten Elements durch die Kopplung mit dem zumindest einen drehbar gelagerten Magneten auf den zumindest einen drehbar gelagerten Magneten übertragbar sind, um den zumindest einen drehbar gelagerten Magneten zu drehen.

Vorteilhaft kann es hierbei sein, wenn das drehbar gelagerte Element an dem freien Ende der Magnetaufnahme und der drehbar gelagerte Magnet an der Schwenkachse der Magnetaufnahme angeordnet sind.

Der Magnetfeldsensor in einem einen Unterdruck oder einen Überdruck aufweisenden Raum angeordnet sein.

Bereit gestellt wird des Weiteren ein System umfassend zwei erfindungsgemäße Messvorrichtungen, wobei die zwei Messvorrichtungen auf unterschiedlichen Seiten des Kabels, vorzugsweise auf zwei gegenüberliegenden Seiten des Kabels, angeordnet sind und jeweils angepasst sind einen Messwert für einen Vorschub des Kabels bezogen auf die jeweilige Messvorrichtung zu ermitteln, wobei aus den ermittelten Messwerten der Vorschub des Kabels bezogen auf das System abgeleitet wird, vorzugsweise durch Bilden eines Mittelwertes aus den ermittelten Messwerten. Damit können eventuelle Messfehler einer Messvorrichtung kompensiert werden. Messfehler können etwa dann auftreten, wenn sich das Kabel während des Vorschubs in radialer Richtung schneller bewegt als die Magnetaufnahme dieser radialen Bewegung folgen kann - dabei kann es zu kurzzeitigen Abweichungen zwischen der Umdrehungsgeschwindigkeit des Magneten und der Vorschubgeschwindigkeit des Kabels kommen.

Bereit gestellt wird des Weiteren ein System umfassend zwei erfindungsgemäße Messvorrichtungen, wobei eine Messvorrichtung an einem Fahrwagen eines Kanalreinigungs- und/oder Kanalinspektionssystems angeordnet ist und wobei die andere Messvorrichtung an einer Kabeltrommel angeordnet ist. "An einer Kabeltrommel angeordnet" bedeutet hierbei, dass die andere Messvorrichtung der Kabeltrommel zugeordnet ist. Dadurch kann der Vorschub eines Kabels sowohl an der Kabeltrommel als auch an dem Fahrwagen gemessen werden. Im günstigsten Fall ist die Abweichung der beiden gemessenen Vorschübe gleich Null oder zumindest vernachlässigbar klein. Weichen die beiden gemessenen Vorschübe voneinander ab, können Maßnahmen getroffen werden, mit denen diese Differenz wieder ausgeglichen wird. Beispielsweise kann der Vorschub an der Kabeltrommel beschleunigt werden, wenn der an der Kabeltrommel gemessene Vorschub kleiner ist als der an dem Fahrwagen gemessene Vorschub.

Bereit gestellt wird ferner ein Verfahren zum Messen eines Vorschubs eines Kabels eines Kanalreinigungs- und/oder Kanalinspektionssystems, wobei
- zumindest ein drehbar gelagerter Magnet derart relativ zum Kabel angeordnet wird, dass ein Vorschub des Kabels ein Drehen des zumindest einen drehbar gelagerten Magneten bewirkt,
- ein Magnetfeldsensor derart relativ zum zumindest einen drehbar gelagerter Magneten angeordnet wird, dass mit ihm Drehungen des zumindest einen drehbar gelagerter Magneten detektierbar sind, wobei aus den detektierten Drehungen der Vorschub des Kabels ermittelt wird, und
- radiale Bewegungen des Kabels während des Vorschubs des Kabels ausgeglichen werden, indem der zumindest eine drehbar gelagerte Magnet den radialen Bewegungen des Kabels folgt, damit auch bei einer radialen Bewegung des Kabels während des Vorschubs des Kabels das Drehen des zumindest einen drehbar gelagerten Magneten bewirkt wird, wobei zum Messen des Vorschubs des Kabels zumindest eine erfindungsgemäße Messvorrichtung verwendet wird.

Bei dem Kabel kann es sich um einen Schiebeaal oder um ein Stromkabel oder um Datenkabel oder um eine Kombination hiervon handeln.

### Kurzbeschreibung der Figuren

Weitere Einzelheiten und Merkmale der Erfindungen sowie konkrete, insbesondere vorteilhafte Ausführungsbeispiele der Erfindung ergeben sich aus der nachfolgenden Beschreibung in Verbindung mit der Zeichnung. Es zeigt:
- Fig. 1: ein Vortriebssystem zum Vorschub eines Kabels;
- Fig. 2: eine perspektivische Ansicht einer Ausgleichseinrichtung einer Messvorrichtung zum Messen eines Vorschubs eines Kabels;
- Fig. 3: die Ausgleichseinrichtung aus Fig. 2 in einer Ansicht von unten;
- Fig. 4: eine Schnittansicht der Messvorrichtung gemäß des in Fig. 1 gezeigten Schnittes A-A;
- Fig. 5: eine Schnittansicht der Messvorrichtung gemäß des in Fig. 1 gezeigten Schnittes B-B;
- Fig. 6: eine Ausgestaltung und deren Funktionsweise einer Messvorrichtung;
- Fig. 7: eine alternative Ausgestaltung und deren Funktionsweise einer Messvorrichtung;
- Fig. 8a: eine erste Variante eines Verfahrens zur Erkennung eines Schlupfes beim Vorschub eines Kabels;
- Fig. 8b: eine zweite Variante eines Verfahrens zur Erkennung eines Schlupfes beim Vorschub eines Kabels;
- Fig. 8c: eine dritte Variante eines Verfahrens zur Erkennung eines Schlupfes beim Vorschub eines Kabels;
- Fig. 9: ein Blockdiagramm eines Vortriebssystems zur Erläuterung eines Verfahrens zur Reduzierung eines Schlupfes beim Vorschub eines Kabels;
- Fig. 10: eine alternative Ausführungsform eines Vortriebssystems; und
- Fig. 11: eine alternative Ausgestaltung und deren Funktionsweise einer Messvorrichtung, die nicht unter dem Schutzbereich der vorliegenden Ansprüche liegt.

### Detaillierte Beschreibung der Erfindung

Nachfolgend werden Ausführungsbeispiele der Erfindung anhand eines Kabels beschreiben. Anstelle eines Kabels kann erfindungsgemäß auch ein Schiebeaal verwendet werden.

Die Gegenstände und Verfahren der vorliegenden Erfindung sind keinesfalls auf die nachfolgend beschriebenen Ausführungsbeispiele beschränkt, sondern dienen vielmehr dem besseren Verständnis der Erfindung. Gleichwohl handelt es sich bei den nachfolgend beschrieben Gegenständen und Verfahren um vorteilhafte Ausgestaltungen der Erfindung.

Sofern nachfolgend von einem "linearen" Vorschub eines Kabels bzw. eines Schiebeaals die Rede ist, ist damit der Vorschub eines Kabels bzw. Schiebeaals, also das Befördern des Kabels bzw. Schiebeaals, entlang seiner Längsachse gemeint. Im Sinne der Erfindung ist damit auch das Abwickeln bzw. Aufwickeln eines Kabels oder eines Schiebeaals von einer Kabeltrommel bzw. auf eine Kabeltrommel mit Hilfe eines Vortriebssystems gemeint.

Mit "Vorschub" ist nachfolgend immer ein Befördern des Kabels bzw. des Schiebeaals in die eine oder in die andere Richtung relativ zum Vortriebssystems gemeint. Das heißt, dass bei einem Vorschub das Kabel bzw. der Schiebeaal in den Kanal hinein geschoben oder aus dem Kanal hinausgeschoben (wenn sich das Vortriebssystem im Kanal, etwa an einem Fahrwagen befindet) bzw. herausgezogen (wenn sich das Vortriebssystem außerhalb des Kanals, etwa an einer Kabeltrommel befindet) werden kann.

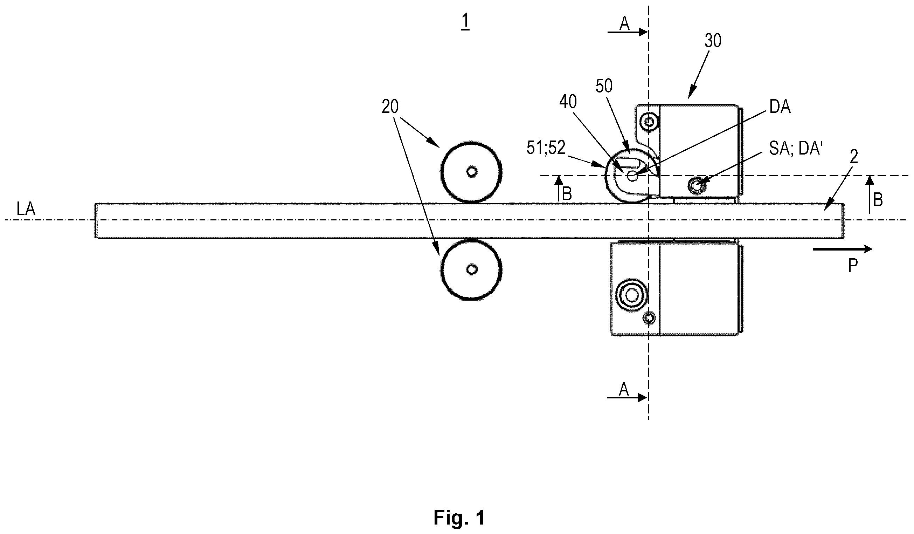

**Fig. 1** zeigt ein Ausführungsbeispiel eines Vortriebssystems 1 zum Vorschub eines Kabels 2 eines Kanalreinigungs- und/oder Kanalinspektionssystems.

Mit dem Vortriebssystem 1 kann das Kabel 2 nach vorne (in Pfeilrichtung P) oder nach hinten (entgegen der Pfeilrichtung P) geschoben bzw. befördert werden. Bei dem Kabel 2 kann es sich um ein relativ starres Kabel handeln, wobei sich das Vortriebssystem 1 auch zum Vorschub von weniger starren bzw. schlaffen Kabeln eignet. Mit dem Vortriebssystem 1 können insbesondere auch Schiebeaale vorgeschoben werden, die in der Regel sehr starr ausgestaltet sind.

Am vorderen Ende des Kabels 2 bzw. Schiebeaals können Inspektionseinheiten (z.B. Kameras) oder Werkzeuge (z.B. Greifer) angeordnet sein.

Das Vortriebssystem 1 weist eine Vortriebseinrichtung 20 auf. Die Vortriebseinrichtung 20 weist hier zwei Räder bzw. Rollen auf, wobei zumindest eines der beiden Räder / Rollen angetrieben ist. Das Kabel ist zwischen den beiden Rädern eingespannt. Mit Hilfe der angetriebenen Räder / Rollen, die auf der Oberfläche des Kabels aufliegen, wird das Kabel bewegt, wenn sich die Räder / Rollen drehen. Das zweite Rad bzw. die zweite Rolle dient als Konterrad bzw. Konterrolle, das nicht angetrieben ist.

Alternativ zu den beiden Rädern / Rollen können auch zwei Antriebsriemen vorgesehen sein, wobei auch hier einer der beiden Riemen angetrieben ist. Es können aber auch beide Riemen angetrieben sein.

In einer noch weiteren Alternative kann die Vortriebseinrichtung 20 eine Rolle / ein Rad und einen Riemen aufweisen, wobei vorzugsweise der Riemen angetrieben ist.

In einer noch weiteren Alternative kann die Vortriebseinrichtung 20 einen Klemmbackenantrieb zum Vorschub des Kabels 2 aufweisen.

Die vorstehend beschriebenen Ausführungsformen einer Vortriebseinrichtung 20 haben gemeinsam, dass bei einem Vorschub des Kabels 2 die Vorschubkraft größer werden kann als die Haftreibung zwischen der Vortriebseinrichtung 20 und dem Kabel 2, was einen Schlupf zwischen dem Kabel und der Vortriebseinrichtung 20 zu Folge haben kann. Die ist insbesondere dann der Fall (aber nicht nur), wenn die Oberfläche des Kabels 2 oder die Rollen / Riemen / Räder verschmutzt oder feucht sind, sodass die Haftreibung zwischen Vortriebseinrichtung 20 und Kabel 2 deutlich reduziert wird.

Eine Herausforderung beim Vorschub eines Kabels 2 eines Kanalreinigungs- und/oder Kanalinspektionssystems ist es, einen solchen Schlupf beim Vorschub des Kabels 2 möglichst unmittelbar nach dem Auftreten zu detektieren, um daraufhin korrigierend in das Vortriebssystem eingreifen zu können, etwas die Vorschubgeschwindigkeit anzupassen oder bei einem extremen Schlupf das Vortriebssystem abzuschalten.

Zur Erkennung / Detektion eines Schlupfes (nachfolgend auch Schlupferkennung genannt) ist die Vortriebseinrichtung 20 angepasst, einen ersten Messwert M1 des Vorschubs bereitzustellen. Der erste Messwert M1 gibt an, wie weit die Vortriebseinrichtung 20 das Kabel 2 unter idealen Bedingungen, d.h. ohne Schlupf vorgeschoben hätte. Der erste Messwert M1 kann beispielsweise aus der Anzahl der Umdrehungen der Antriebsräder abgeleitet werden. Die Vortriebseinrichtung 20 weist hierfür geeignete Detektionsmittel auf, die an sich aus dem Stand der Technik bekannt sind. Bei einem Schlupf weicht der erste Messwert M1 allerdings von dem tatsächlichen Vorschub ab.

Ferner umfasst das Vortriebssystem 1 eine Messvorrichtung 10 zum Messen des Vorschubs des Kabels 2, wobei in Fig. 1 von der Messvorrichtung nur die Ausgleichseinrichtung 30 zu sehen ist. Mit der Messvorrichtung wird ein Vorschub des Kabels unabhängig von der Vortriebseinrichtung 20 detektiert bzw. gemessen.

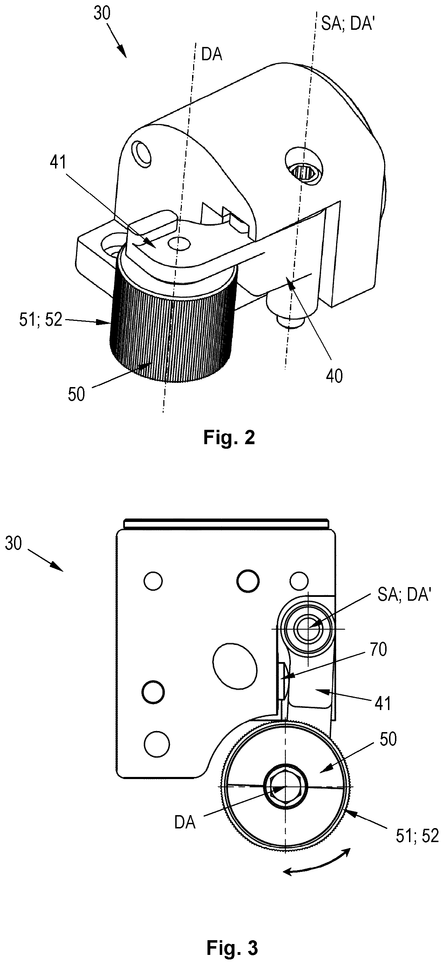

Die Messvorrichtung weist hier eine Ausgleichseinrichtung 30 und einen Magnetfeldsensor, der in Fig. 1 nicht zu sehen ist, auf. Der Magnetfeldsensor ist angepasst, Drehungen eines Magneten, der Bestandteil der Ausgleichseinrichtung 30 ist, zu detektieren, wobei aus der Anzahl der detektierten Drehungen des Magneten ein Maß für den Vorschub des Kabels 2 abgeleitet werden kann. Basierend auf der Anzahl der detektierten Drehungen des Magneten stellt die Messvorrichtung unabhängig von der Vortriebseinrichtung 20 einen zweiten Messwert M2 des Vorschubs bereit. Der zweite Messwert M2 gibt an, wie weit das Kabel 2 tatsächlich vorgeschoben wurde. Die Messeinrichtung ist mit Bezug auf Fig. 2 bis Fig. 7 detailliert beschrieben.

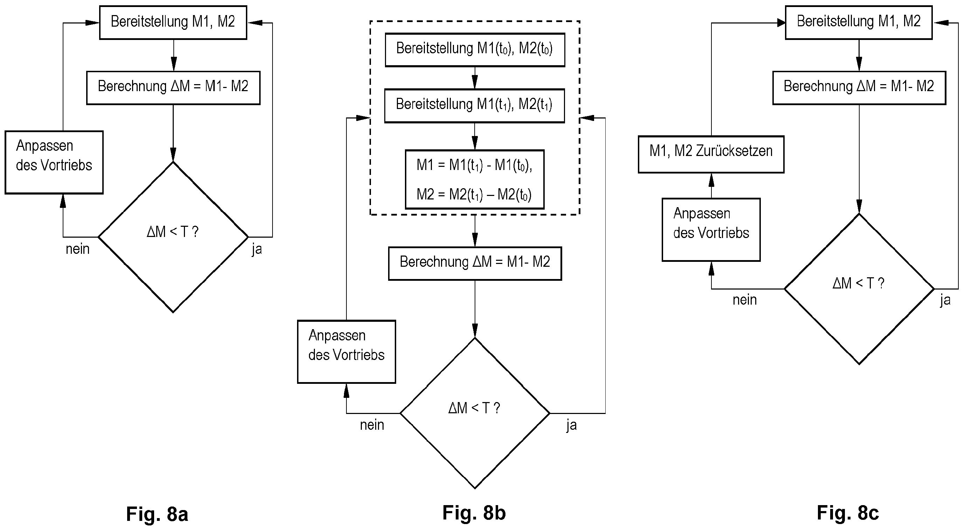

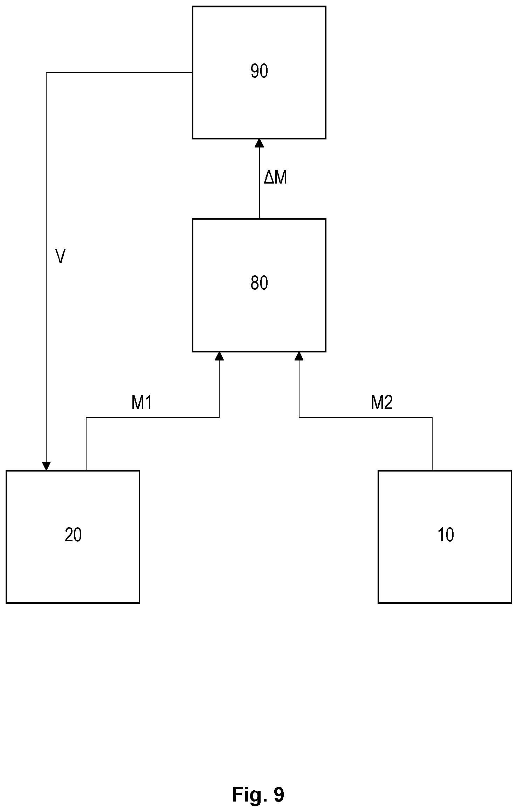

Das Vortriebssystem 1 weist zudem eine Auswerteeinheit 80 (siehe Fig. 9) auf, die angepasst ist, den von der Vortriebseinrichtung 20 bereitgestellten ersten Messwert M1 und den von der Messvorrichtung 10 bereitgestellten zweiten Messwert M2 zu verarbeiten. Die Verfahrensschritte zur Verarbeitung der beiden Messwerte M1, M2 und die damit ermöglichte Reduzierung des Schlupfes des Kabels 2 sind mit Bezug auf Fig. 8 detailliert beschrieben.

Im Wesentlichen berechnet die Auswerteeinheit 80 eine Differenz ΔM zwischen dem ersten Messwert M1 und dem zweiten Messwert M2, und vergleicht diese Differenz mit einem vorbestimmten Schwellenwert T. Wird der Schwellenwert T überschritten, liegt ein bestimmtes Maß an Schlupf vor, der reduziert werden sollte bzw. reduziert werden muss.

Ist der Betrag der Differenz ΔM gleich Null, dann wird das Kabel ohne Schlupf vorgeschoben. Liegt der Betrag der Differenz ΔM zwischen Null und dem Schwellenwert T, dann liegt ein Schlupf vor, der toleriert werden kann. In einer Ausgestaltung der Erfindung kann es vorgesehen sein, den Schlupf auch dann zu reduzieren, wenn die Differenz ΔM zwischen Null und dem Schwellenwert T liegt, sodass eine kontinuierliche Regelung des Vorschubes vorgenommen werden kann.

Zur Reduzierung des Schlupfes umfasst das Vortriebssystem 1 oder die Auswerteeinheit 80 eine Steuereinrichtung 90, wobei die Steuereinrichtung angepasst ist, den Vorschub des Kabels 2 durch die Vortriebseinrichtung 20 zu steuern. In einer Ausgestaltung der Erfindung kann der Vorschub des Kabels 2 durch die Vortriebseinrichtung 20 verlangsamt werden, wenn der Betrag der Differenz ΔM zwischen dem ersten Messwert M1 und dem zweiten Messwert M2 den vorbestimmten Schwellenwert T überschreitet. Es kann aber auch vorgesehen sein, den Vorschub des Kabels 2 durch die Vortriebseinrichtung 20 zu verlangsamen, sobald der Betrag der Differenz ΔM zwischen dem ersten Messwert M1 und dem zweiten Messwert M2 größer Null ist.

Die Steuereinrichtung 90 kann angepasst sein, den Vorschub bzw. die Vortriebseinrichtung so lange zu verlangsamen, vorzugsweise stufenweise zu verlangsamen, bis der Betrag der Differenz ΔM zwischen dem ersten Messwert M1 und dem zweiten Messwert M2 den vorbestimmten Schwellenwert T wieder unterschreitet bzw. bis der Betrag der Differenz ΔM zwischen dem ersten Messwert M1 und dem zweiten Messwert M2 wieder Null bzw. nahe Null ist.

In einer alternativen Ausgestaltung kann es auch vorgesehen sein, den Vorschub des Kabels 2 zu beschleunigen, wenn der vorbestimmte Schwellenwert T überschritten wird. Dies kann etwa dann erforderlich sein, wenn das vorgeschobene Kabel aufgrund des Schlupfes und der damit einhergehenden reduzierten Vorschubgeschwindigkeit gegenüber einer anderen im Kanal vorgeschobenen Einheit zurückbleibt, also wegen des Schlupfes langsamer vorgeschoben wird als die andere Einheit. Beispielsweise können zwei Kabel unabhängig voneinander in einen Kanal geschoben werden, etwa jeweils mit einem hier gezeigten Vortriebssystem 1. Tritt nun in dem einen Vortriebssystem ein Schlupf am Kabel auf, während in dem anderen Vortriebssystem kein Schlupf auftritt, dann bleibt das von dem einen Vortriebssystem vorgeschobene Kabel gegenüber dem anderen Kabel zurück. Um diesen vom Schlupf verursachten "Rückstand" aufzuholen, wird der Vorschub des Kabels beschleunigt.

In einer weiteren Ausgestaltung der Erfindung kann das Kabel 2 mit zwei voneinander unabhängigen Vortriebseinrichtungen 20 vorgeschoben werden. Eine Vortriebseinrichtung kann hierbei auf einem sich im Kanal befindlichen Fahrwagen angeordnet sein, der beispielsweise einen Schiebeaal in einen Seitenkanal einschiebt. Die andere Vortriebseinrichtung kann an einer Kabeltrommel angeordnet sein, die sich außerhalb des Kanals befindet, und die den Schiebeaal von der Kabeltrommel abwickelt und in den Kanal (in Richtung Fahrwagen) einschiebt. Hierbei kann es vorkommen, dass die Vortriebseinrichtung des Fahrwagens den Schiebeaal ohne Schlupf in den Seitenkanal einschiebt, während die Vortriebseinrichtung der Kabeltrommel den Schiebeaal mit Schlupf in den Kanal einschiebt. Um den durch den Schlupf an der Kabeltrommel verursachten geringeren Vorschub gegenüber dem Vorschub an dem Fahrwagen, kann es vorgesehen sein, den Vorschub durch die Vortriebseinrichtung der Kabeltrommel zu beschleunigen.

Die Vortriebseinrichtung 20 ist demnach vorgesehen den Vorschub (in Pfeilrichtung P bzw. entgegen der Pfeilrichtung P) des Kabels 2 zu bewirken und gleichzeitig einen ersten Messwert M1 bereitzustellen, der den Soll-Vorschub repräsentiert (der Soll-Vorschub kann aufgrund eines Schlupfes von dem tatsächlich bewirkten Vorschub (= Ist-Vorschub) abweichen). Die Messvorrichtung 10 ist demnach zum Messen des effektiven Vorschubs des Kabels 2 (= Ist-Vorschub, der als zweiter Messwert M2 bereitgestellt wird), d.h. des tatsächlich von der Vortriebseinrichtung 20 bewirkten Vorschubs, vorgesehen. Wird das Kabel 2 von der Vortriebseinrichtung 20 ohne jeglichen Schlupf vorgeschoben, weichen die beiden Messwerte M1 und M2 nicht voreinander ab, bzw. weichen lediglich um einen vernachlässigbar kleinen Wert voneinander ab.

Wie vorstehend erläutert, kann die Steuereinrichtung 90 angepasst sein, den Vorschub anzupassen (zu beschleunigen oder zu verlangsamen), wenn die Differenz ΔM zwischen dem ersten Messwert M1 und dem zweiten Messwert M2 den vorbestimmten Schwellenwert T überschreitet. In einer Ausgestaltung der Erfindung kann es aber auch vorgesehen sein, den Vorschub anzupassen, wenn der Betrag der Differenz ΔM zwischen Null und dem Schwellenwert T ist. Beispielsweise kann durch ein Beschleunigen der Vortriebseinrichtung (z.B. Antriebsriemen oder Antriebsrad) gegebenenfalls wieder mehr Haftreibung zwischen der Vortriebseinrichtung und dem Schiebeaal / Kabel hergestellt werden, sodass die Differenz vor Erreichen des Schwellenwerts T ausgleichen bzw. reduziert werden kann. Wird der Schwellenwerts T dennoch überschritten, können alternative Maßnahmen eingeleitet werden, etwas das gesamte System abgeschaltet werden, um eine Beschädigung des Systems und/oder des Schiebeaals / Kabels zu vermeiden.

Im Folgenden werden mit Bezug auf Fig. 2 bis Fig. 7 Ausgestaltungen einer Messvorrichtung 10 gezeigt. Einerseits kann die Messvorrichtung 10, wie mit Bezug auf Fig. 1 beschrieben, Teil eines Vortriebssystems 1 sein und damit einen wesentlichen Beitrag zur Detektion eines Schlupfes des Kabels 2 liefern. Andererseits kann die Messvorrichtung unabhängig von einem Vortriebssystem zum Messen eines Vorschubs eines Kabels 2 verwendet werden.

**Fig. 2** zeigt eine perspektivische Ansicht einer Ausgleichseinrichtung 30 einer Messvorrichtung 10 zum Messen eines Vorschubs eines Kabels 2.

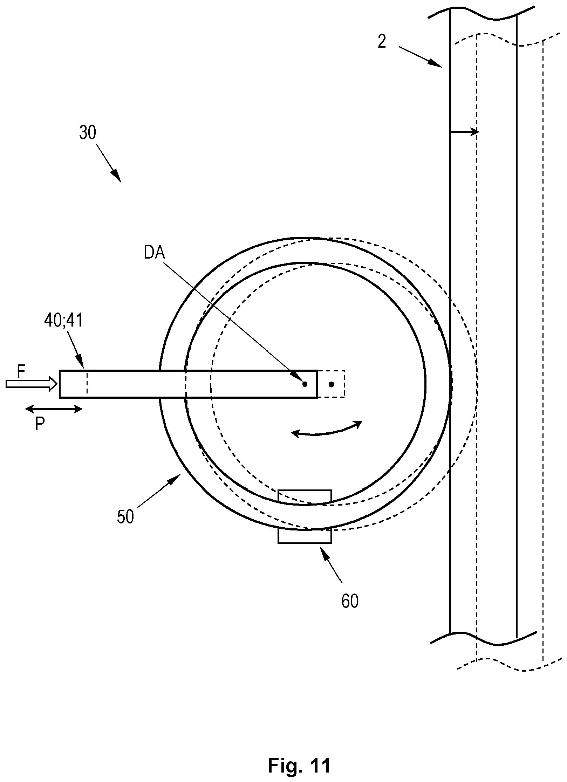

Die Ausgleichseinrichtung 30 umfasst einen um eine Drehachse DA drehbar gelagerten Magneten 50 und eine Magnetaufnahme 40 zur Aufnahme des Magneten 50. Die Magnetaufnahme 40 ist hier als eine um eine Schwenkachse SA schwenkbarbare Schwenkeinrichtung ausgestaltet. Eine alternative Ausgestaltung einer Ausgleichseinrichtung 30 ist mit Bezug auf Fig. 11 beschrieben.

Die Schwenkeinrichtung 40 weist in der in Fig. 2 dargestellten Ausgestaltung einen Schwenkarm 41 auf, an dessen freiem Ende der um die Drehachse DA drehbar gelagerter Magnet 50 angeordnet ist. Der Schwenkarm 41 wir durch Beaufschlagung einer Stellkraft verschwenkt. Die Stellkraft wird von einem Stellglied bzw. Stellmittel, etwa ein Federelement, bereitgestellt. Die auf den Schwenkarm wirkende Stellkraft bewirkt, dass das frei Ende des Schwenkarms 41 und damit auch der dort angeordnete Magnet 50 in Richtung des Kabels 2 geschwenkt wird.

Der drehbar gelagerte Magnet 50 ist hier diametral magnetisierter Ringmagnet ausgestaltet, wobei der Magnet 50 auch ein diametral magnetisierter Scheibenmagnet sein kann oder andere Form aufweisen kann, solange der Magnet 50 senkrecht zur Drehachse DA magnetisiert ist. Der Magnet 50 weist zumindest einen Nordpol und zumindest einen Südpol auf. In Fig. 2 ist der Magnet 50 an der Unterseite eines drehbar gelagerten Elements 52 angeordnet.

Das drehbar gelagerte Element 52 bildet in dieser Ausführungsform gleichzeitig ein Gehäuse 51, in dem der Magnet 50 angeordnet ist. Das Gehäuse 51 kann im Allgemeinen eine um die Drehachse DA drehsymmetrische Form aufweisen, wobei die in Fig. 2 gezeigte Zylinderform lediglich beispielhaft ist.

In einer Ausgestaltung kann das Gehäuse 51 eine konkav gekrümmte Oberfläche aufweisen, die an eine konvex gekrümmte Oberfläche des Kabels 2 angepasst ist, sodass das Gehäuse einen effektiven Beitrag zur Führung des Kabels 2 bewirkt. Bewegungen des Kabels entlang der Längsachse des Gehäuses 51 können so reduziert bzw. vermieden werden.

Beim Vorschub des Kabels 2 wird das Kabel 2 an der Ausgleichseinrichtung 30 vorbeigeführt. Der drehbar gelagerte Magnet 50 ist dabei derart an der Magnetaufnahme 40 bzw. an der Schwenkeinrichtung 40 angeordnet, dass durch den Vorschub des Kabels 2 Drehungen des Magneten 50 um die Drehachse DA bewirkt werden. Ferner ist die Magnetaufnahme 40 bzw. die Schwenkeinrichtung 40 der Ausgleichseinrichtung 30 angepasst, einer Bewegung des Kabels 2, insbesondere einer Bewegung des Kabels in radialer Richtung, während des Vorschubs zu folgen. Dadurch wird gewährleistet, dass auch bei einer radialen Bewegung des Kabels 2, d.h. wenn sich das Kabel von dem Magneten 50 wegbewegt, während des Vorschubs die Drehung des Magneten 50 durch das Kabel 2 bewirkt wird. In der in Fig. 2 gezeigten Ausgestaltung berührt das Gehäuse 51 bzw. das drehbar gelagerte Element 52 das Kabel 2 (siehe Fig. 1), sodass der lineare Vorschub des Kabels 2 Drehungen des drehbar gelagerten Elements 52 und somit des drehbar gelagerten Magneten 50 um die Drehachse DA bewirkt.

**Fig. 3** zeigt die Ausgleichseinrichtung 30 aus Fig. 2 in einer Ansicht von unten.

Diese Ansicht zeigt auch eine Ausgestaltung Stellglieds 70 als Federelement. Das Mittels der von dem Federelement bereitgestellten Federkraft wird der Schwenkarm 41 mit einer Stellkraft beaufschlagt, was ein Schwenken der Schwenkeinrichtung 40 um die Schwenkachse SA bewirkt. Dadurch wird gewährleistet, dass die Magnetaufnahme 40 bzw. die Schwenkeinrichtung 40 der radialen Bewegung des Kabels 2 folgt, da die auf den Schwenkarm 41 wirkende Federkraft gewährleistet, das freie Ende des Schwenkarms 41 permanent gegen das vorbeigeführte Kabel 2 gedrückt wird.

Der Magnet 50 ist in einem um die Drehachse DA drehbar gelagerten Element 52 angeordnet, wobei das drehbar gelagerte Element 52 ein Gehäuse 51 für den drehbar gelagerten Magneten 50 bildet und hier an dem freien Ende des Schwenkarms 41 angeordnet ist. Durch die Stellkraft des Stellglieds 70 bzw. des Federelements 70 wird der Schwenkarm 41 der Schwenkeinrichtung 40 derart in Richtung des Kabels 2 gedrückt, dass das Gehäuse 51 bzw. das drehbar gelagerte Element 52 das Kabel 2 berühren. Dadurch wird bewirkt, dass ein Vorschub des Kabels 2 das drehbar gelagerte Element 52 bzw. das Gehäuse 51 in eine Rotation versetzt, wodurch auch der in dem drehbar gelagerten Element 52 bzw. Gehäuse 51 angeordnet Magnet in einer Rotation um die Drehachse DA versetzt wird.

In einer weiteren Ausgestaltung kann das Stellglied 70 bzw. das Federelement 70 in die Schwenkachse SA integriert sein, und somit ebenso eine Stellkraft erzeugen, die ein Schwenken der Magnetaufnahme 40 bzw. der Schwenkeinrichtung 40 um die Schwenkachse SA bewirkt.

Die Positionsangaben "links", "rechts", "unten" und "oben" beziehen sich im Folgenden auf das vorzuschiebende Kabel 2.

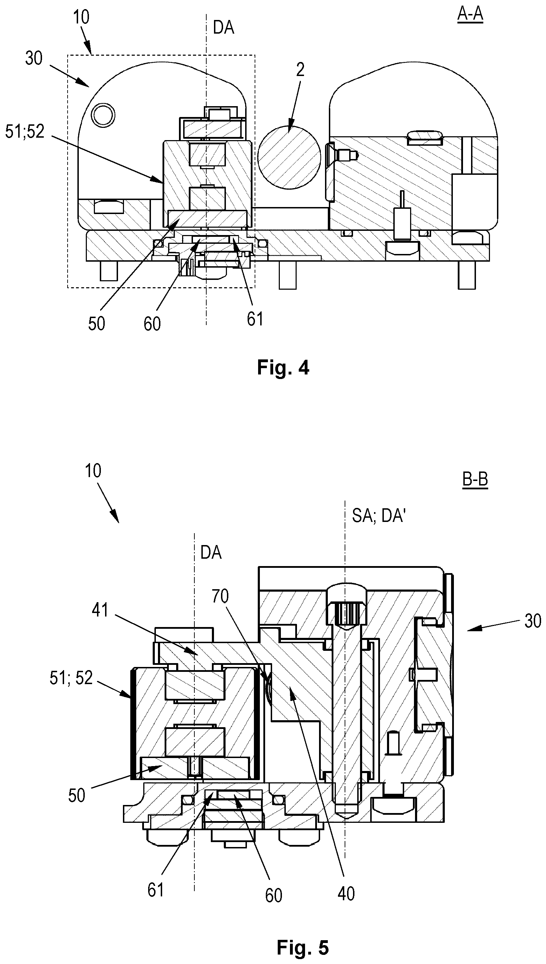

**Fig. 4** zeigt eine Schnittansicht der Messvorrichtung 10 gemäß des in Fig. 1 gezeigten Schnittes A-A.

In der Darstellung der Fig. 4 ist die Ausgleichseinrichtung 30 links vom vorzuschiebenden Kabel 2 angeordnet. Gleichermaßen denkbar wäre eine Anordnung der Messvorrichtung 10 rechts, unterhalb oder oberhalb des vorzuschiebenden Kabels 2.

Der Magnet 50 ist hier in einem Gehäuse 51 angeordnet, das seinerseits drehbar um die Drehachse DA gelagert ist. Dadurch ist auch der Magnet 50 um die Drehachse DA drehbar.

In einer Ausgestaltung der Erfindung kann der Magnet 50 auch ohne Gehäuse drehbar um die Drehachse DA an dem Schwenkarm angeordnet sein. Dies gilt gleichermaßen für alle gezeigten Ausführungsformen der Erfindung.

Beabstandet zum drehbar gelagerten Magneten 50 der Ausgleichseinrichtung 30 ist der Magnetfeldsensor 60 angeordnet. Der Magnetfeldsensor 60 ist hierbei stationär, d.h. nicht bewegbar angeordnet, sodass sich der Magnet 50 relativ zum Magnetfeldsensor 60 dreht. In der in Fig. 4 gezeigten Ausgestaltung ist der Magnetfeldsensor 60 unterhalb des Magneten 50 angeordnet.

In der in Fig. 4 gezeigten Ausgestaltung ist der Magnetfeldsensor 60 in einem einen Überdruck aufweisenden Raum 61 angeordnet. Eine Anordnung in einem einen Unterdruck aufweisenden Raum ist ebenfalls möglich.

Vorteilhaft ist es, wenn der Magnetfeldsensor 60 versetzt zur Drehachse DA des Magneten 50 angeordnet ist. Dadurch wird gewährleistet, dass der Magnetfeldsensor 60 die Drehungen des Magneten 50, der hier als diametral magnetisierter Ringmagnet ausgestaltet ist, detektieren kann. Die Drehungen des Magneten 50 bewirken im Messbereich des Magnetfeldsensors 60 eine zeitliche Änderung des magnetischen Flusses, wodurch die Drehungen des Magneten 50 detektierbar werden. Die von dem Magnetfeldsensor 60 detektierten Drehungen sind ein Maß für den Vorschub des Kabels 2.

In einer weiteren, hier nicht gezeigten Ausführungsform, könne zwei Messvorrichtungen 10 vorgesehen sein, wobei eine Messvorrichtungen 10 an der einen Seite des Kabels 2 und die andere Messvorrichtungen 10 an der anderen (gegenüberliegenden) Seite des Kabels 2 angeordnet sind. Die Magnetfeldsensoren 60 der beiden Messvorrichtungen 10 können so unabhängig voneinander die Drehungen des jeweiligen Magneten detektieren. Aus den von den beiden Messvorrichtungen 10 bereitgestellten Messwerten kann ein Mittelwert gebildet werden, der dann als Maß für den Vorschub des Kabels 2 verwendet werden kann.

**Fig. 5** zeigt eine Schnittansicht der Messvorrichtung bzw. der Ausgleichseinrichtung 30 gemäß des in Fig. 1 gezeigten Schnittes B-B.

Gut erkennbar ist hier der Schwenkarm 41, an dessen freien Ende der Magnet 50 angeordnet ist. der Magnet 50 ist auch hier in einem Gehäuse 51 untergebracht, das drehbar um die Drehachse DA an dem Schwenkarm 41 angeordnet ist. Ebenfalls gut erkennbar sind hier die zur Drehachse DA versetzte Anordnung des Magnetfeldsensors 60 und das Stellglied 70, das hier von hinten gegen den Schwenkarm 41 drückt.

In einer weiteren Ausgestaltung der Messvorrichtung 10 kann der Magnetfeldsensor 60 an der Magnetaufnahme 40 bzw. am Schwenkarm 41 beabstandet zum Magneten 50 angeordnet sein. Der um die Drehachse DA drehbar gelagerte Magnet 50 kann ach in dieser Ausgestaltung am freien Ende des Schwenkarms 41 angeordnet sein. Vorteilhaft kann es auch hierbei sein, wenn der Magnetfeldsensor 60 versetzt zur Drehachse DA des Magneten angeordnet ist.

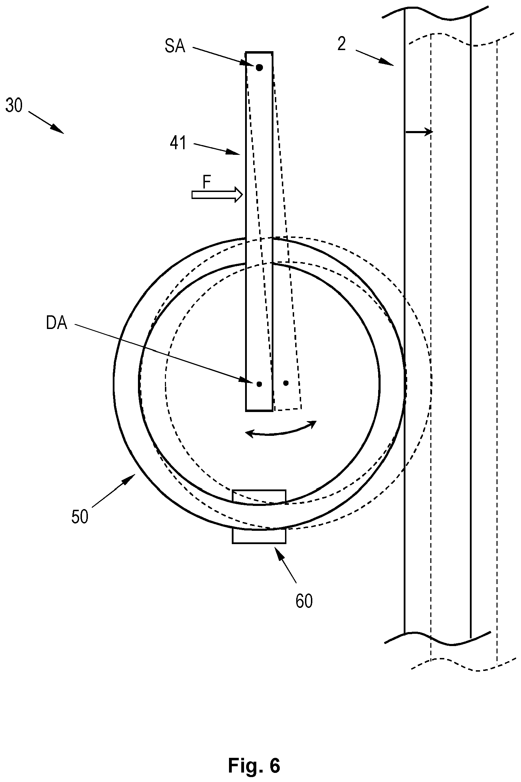

**Fig. 6** zeigt die Funktionsweise der Schwenkeinrichtung 40 einer Ausgestaltung der Ausgleichseinrichtung 30.

Die Schwenkeinrichtung ist schwenkbar um die Schwenkachse SA angeordnet und umfasst einen Schwenkarm 41. An dem freien Ende des Schwenkarms 41 ist ein um eine Drehachse DA drehbar gelagerter Magnet 50 angeordnet, wobei der drehbar gelagerte Magnet das Kabel 2 berührt. Beabstandet zu dem drehbar gelagerten Magneten 50 ist ein Magnetfeldsensor 60 angeordnet, der angepasst ist, Drehungen des drehbar gelagerten Magneten 50 um die Drehachse DA zu detektieren, wobei die detektierten Drehungen ein Maß für den Vorschub des Kabels 2 sind.

Bei einer radialen Bewegung des Kabels 2, dargestellt in Fig. 6 durch die gestrichelten Linien, folgt der drehbar gelagerte Magnet 50 dem Kabel 2 durch ein Schwenken der Schwenkeinrichtung 40 bzw. durch ein Schwenken des Schwenkarms 41 um die Schwenkachse SA. Das Schwenken des Schwenkarms 41 kann mittels einer auf den Schwenkarm 41 wirkenden Stellkraft F bewirkt werden. Die Stellkraft F kann beispielsweise von einem Federelement bereitgestellt werden.

Dadurch wird gewährleistet, dass der drehbar gelagerte Magnet 50 das Kabel 2 auch bei einer radialen Bewegung des Kabels 2 berührt, sodass das Kabel 2 bei einem Vorschub kontinuierlich Drehungen des drehbar gelagerten Magneten 50 um die Drehachse DA bewirkt.

Der drehbar gelagerte Magnet 50 ist möglichst reibungsarm gelagert.

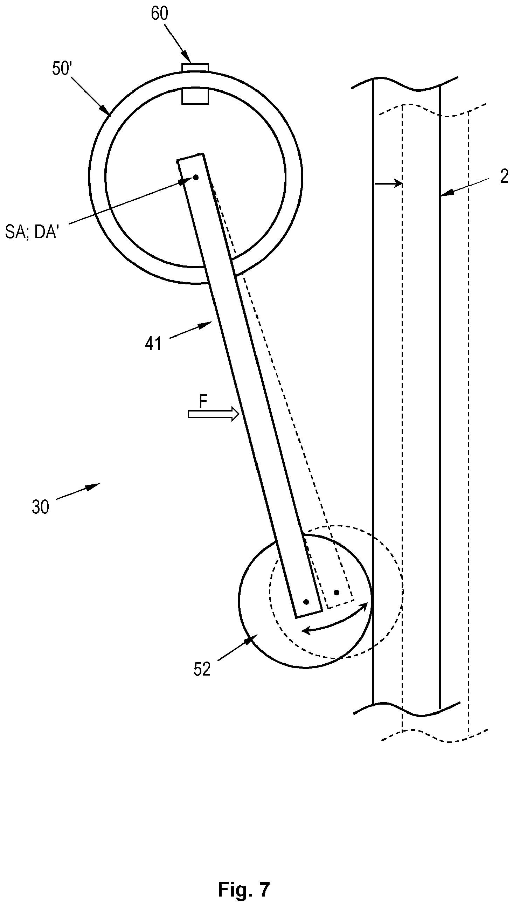

**Fig. 7** zeigt die Funktionsweise der Schwenkeinrichtung 40 einer alternativen Ausgestaltung der Ausgleichseinrichtung 30.

Die Schwenkeinrichtung 40 ist auch hier schwenkbar um die Schwenkachse SA angeordnet und umfasst einen Schwenkarm 41. Gemäß dieser alternativen Ausgestaltung ist der Magnet 50' drehbar um die Schwenkachse SA angeordnet. In diesem Fall stimmt die Drehachse DA', um die der Magnet drehbar ist, mit der Schwenkachse SA überein. Der Magnet 50' kann auch in dieser Ausgestaltung in einem Gehäuse 51 angeordnet sein.

In dieser alternativen Ausgestaltung ist an dem freien Ende des Schwenkarms 41 ein um eine Drehachse drehbar gelagertes Element 52 derart angeordnet, dass durch den Vorschub des Kabels 2 Drehungen des drehbar gelagerten Elements 52 bewirkt werden.

Das drehbar gelagerte Element 52 ist mit drehbar gelagerten Magneten 50' koppelbar bzw. gekoppelt. Das drehbar gelagerte Element 52 und der drehbar gelagerte Magnet 50' können beispielsweise über einen Riemen gekoppelt sein. Durch die Kopplung können Drehungen des drehbar gelagerten Elements 52 auf den drehbar gelagerten Magneten 50' übertragen werden, um den drehbar gelagerten Magneten 50' zu drehen.

Der Magnetfeldsensor 60 ist beabstandet zu dem drehbar gelagerten Magneten 50' angeordnet, und angepasst, Drehungen des drehbar gelagerten Magneten 50' um die Drehachse DA' zu detektieren, wobei auch hier die detektierten Drehungen ein Maß für den Vorschub des Kabels 2 sind.

Bei einer radialen Bewegung des Kabels 2, dargestellt in Fig. 7 durch die gestrichelten Linien, folgt das drehbar gelagerte Element 52 durch ein Schwenken des Schwenkarms 41 dem Kabel 2. Das Schwenken des Schwenkarms 41 kann auch hier mittels einer auf den Schwenkarm 41 wirkenden Stellkraft F bewirkt werden. Die Stellkraft F kann beispielsweise von einem Federelement bereitgestellt werden.

Dadurch wird gewährleistet, dass das drehbar gelagerte Element 52 das Kabel 2 auch bei einer radialen Bewegung des Kabels 2 berührt, sodass das Kabel 2 bei einem Vorschub kontinuierlich Drehungen des drehbar gelagerten Elements 52 um die Drehachse DA bewirkt, wobei die Drehungen des Elements 52 aufgrund der Kopplung auch Drehungen des Magneten 50' um die Drehachse DA' bewirken.

**Fig. 8a** zeigt ein Ablaufdiagramm einer ersten Variante eines Verfahrens zur Erkennung eines Schlupfes beim Vorschub eines Kabels 2.

In dem Verfahren zur Reduzierung eines Schlupfes eines Kabels 2 wird ein erster Messwert M1 des Vorschubs des Kabels 2 ermittelt. Ferner wird unabhängig vom ersten Messwert M1 ein zweiter Messwert M2 des Vorschubs des Kabels 2 ermittelt. Der erste Messwert M1 und der zweite Messwert M2 können dabei mit einer vorbestimmten Frequenz ermittelt werden. Der zweite Messwert M2 repräsentiert hierbei den tatsächlich geleisteten Vorschub des Kabels 2 (= Ist-Vorschub).

Zwischen dem ersten Messwert M1 und dem zweiten Messwert M2 wird eine Differenz ΔM gebildet, und der Vorschub des Kabels 2 wird angepasst (verlangsamt oder beschleunigt), wenn der Betrag der Differenz ΔM einen vorbestimmten Schwellenwert T übersteigt.

In einer Ausgestaltung des Verfahrens kann der zweite Messwert M2 mit Hilfe der vorstehend beschriebenen Messvorrichtung 10 ermittelt werden. Zum Ermitteln des zweiten Messwertes M2 wird dabei ein drehbar gelagerter Magnet 50; 50' an dem Kabel 2 angeordnet, der durch den Vorschub des Kabels 2 gedreht wird. Ferner wird ein Magnetfeldsensor 60 relativ zum Magneten 50; 50' angeordnet, wobei mit dem Magnetfeldsensor 60 die Drehungen des Magneten 50; 50' detektiert werden, sodass aus den detektierten Drehungen der zweite Messwert M2 abgeleitet werden kann. Dies gilt auch für die mit Bezug auf Fig. 8b und Fig. 8c beschriebenen Verfahren.

In einer alternativen Ausgestaltung des erfindungsgemäßen Verfahrens kann der Vorschub des Kabels 2 so lange angepasst werden, vorzugsweise stufenweise angepasst werden, bis der Betrag der Differenz ΔM zwischen dem ersten Messwert M1 und dem zweiten Messwert M2 den vorbestimmten Schwellenwert T wieder unterschreitet.

**Fig. 8b** zeigt eine Variante des Verfahrens, bei der die Messwerte M1 und M2 jeweils den Unterschied des Vorschubs des Kabels 2 über ein vorbestimmtes Zeitintervall repräsentieren.

**Fig. 8c** zeigt eine weitere Variante des Verfahrens, bei der die Messwerte M1 und M2 jeweils den zuletzt gemessenen Vorschub des Kabels 2 repräsentieren. Die zwei Varianten werden im Folgenden anhand eines Durchlaufs der Verfahrensschritte beschrieben.

Bei der in Fig. 8b gezeigten Variante kann der lineare Vorschub des Kabels 2 beispielsweise mit einer vorbestimmten Frequenz gemessen werden. Die zum Messzeitpunkt t₀ gemessenen Werte für den ersten Messwert M1(t₀) und den zweiten Messwert M2(t₀) des Vorschub des Kabels werden zwischengespeichert und bereitgestellt. Ebenso werden die gemessenen Werte zum aktuellen Messzeitpunkt ti, also der erste Messwert M1(t₁) und der zweite Messwert M2(t₁) für den Vorschub des Kabels 2 bereitgestellt und zwischengespeichert. Aus den bereitgestellten Messwerten werden der erste Messwert M1 und der zweite Messwert M2 jeweils aus der Differenz zwischen den Messwerten zum aktuellen Messzeitpunkt t₁ und den Messwerten zum vorherigen Messzeitpunkt t₀ ermittelt. Somit repräsentieren der erste Messwert M1 und der zweite Messwert M2 jeweils die im zuletzt verstrichenen Zeitintervall zwischen t₀ und t₁ linear vorgeschobene Strecke des Kabels 2.

Zwischen dem ersten Messwert M1 und dem zweiten Messwert M2 wird eine Differenz ΔM gebildet, und der Vorschub des Kabels 2 wird angepasst, wenn der Betrag der Differenz ΔM einen vorbestimmten Schwellenwert T übersteigt. Vor dem nächsten Durchlauf werden die Messwerte zum aktuellen Messzeitpunkt t₁ als Messwerte für den vorherigen Messzeitpunkt t₀ zwischengespeichert.

Bei der in Fig. 8c gezeigten Variante kann der Vorschub des Kabels 2 ebenso mit einer vorbestimmten Frequenz gemessen werden. Dabei werden der erste Messwert M1 und der zweite Messwert M2 jeweils zum aktuellen Messzeitpunkt ermittelt und bereitgestellt. Die Messwerte von vorherigen Messzeitpunkten werden im Gegensatz zu der in Fig. 8b gezeigten Variante nicht mehr benötigt. Zwischen dem ersten Messwert M1 und dem zweiten Messwert M2 wird eine Differenz ΔM gebildet, und der Vorschub des Kabels 2 wird verlangsamt, wenn der Betrag der Differenz ΔM einen vorbestimmten Schwellenwert T übersteigt. Falls ein Schlupf des Kabels 2 erkannt wurde, werden für die nächste Prüfung eines Schlupfes des Kabels 2 der erste Messwert M1 und der zweite Messwert M2 jeweils auf null zurückgesetzt.

In einer weiteren, hier nicht gezeigten Variante können der erste Messwert M1 und der zweite Messwert M2 auch jeweils aus einer Mehrzahl an Messungen über einen vorbestimmten Zeitraum gemittelt werden, oder anderweitig gefiltert werden, um ein Rauschen des ersten Messwerts M1 und/oder des zweiten Messwerts M2 zu minimieren.

**Fig. 9** zeigt ein Blockdiagramm eines Vortriebssystems 1 zur Erläuterung eines Verfahrens zur Reduzierung eines Schlupfes beim Vorschub eines Kabels 2.

Die Vortriebseinrichtung 20 des Vortriebssystems 1 ist angepasst, ein Kabel 2 vorzuschieben, und dabei einen ersten Messwert M1 des Vorschubs (=Soll-Vorschub) des Kabels 2 bereitzustellen. Ferner ist die Messvorrichtung 10 des Vortriebssystems 1 angepasst, einen zweiten Messwert M2 des Vorschubs (=Ist-Vorschub) des Kabels 2 bereitzustellen.

Der erste Messwert M1 und der zweite Messwert M2 werden einer Auswerteeinrichtung 80 zur Verfügung gestellt bzw. übergeben, wobei in der Auswerteeinrichtung 80 eine Differenz ΔM zwischen dem ersten Messwert M1 und dem zweiten Messwert M2 gebildet wird.

In einer Variante des Verfahrens, in der der erste Messwert M1 und/oder der zweite Messwert M2 wie oben beschrieben aus einer Mehrzahl an Messwerten ermittelt bzw. gefiltert werden, kann die Auswerteeinrichtung 80 auch den ersten Messwert M1 und/oder den zweiten Messwert M2 aus der Mehrzahl an Messwerten ermitteln bzw. filtern.

Der erste Messwert M1 und der zweite Messwert M2 werden zum gleichen Zeitpunkt bzw. über den gleichen Zeitraum ermittelt, sodass die Differenz ΔM zwischen dem ersten Messwert M1 und dem zweiten Messwert M2 bei einem Vorschub des Kabels 2 ohne Schlupf unter einem vorbestimmten Schwellenwert T ist, also im Wesentlichen null ist.

Die Auswerteeinrichtung 80 ist mit einer Steuereinrichtung 90 gekoppelt bzw. koppelbar, sodass zwischen der Auswerteinrichtung 80 und der Steuereinrichtung 90 Daten und gegebenenfalls Programmbefehle ausgetauscht werden können. Die Steuereinrichtung 90 steuert den Vorschub des Kabels 2 durch die Vortriebseinrichtung 20. Wenn der Betrag der Differenz ΔM einen vorbestimmten Schwellenwert T übersteigt, bewirkt die Steuereinrichtung 90 eine Anpassung V des Vorschubs des Kabels 2. Durch die Anpassung V des Vorschubs kann der Schlupf des Kabels 2 reduziert werden.

Die Auswerteeinrichtung 80 und die Steuereinrichtung 90 können als eine Einheit ausgeführt sein.

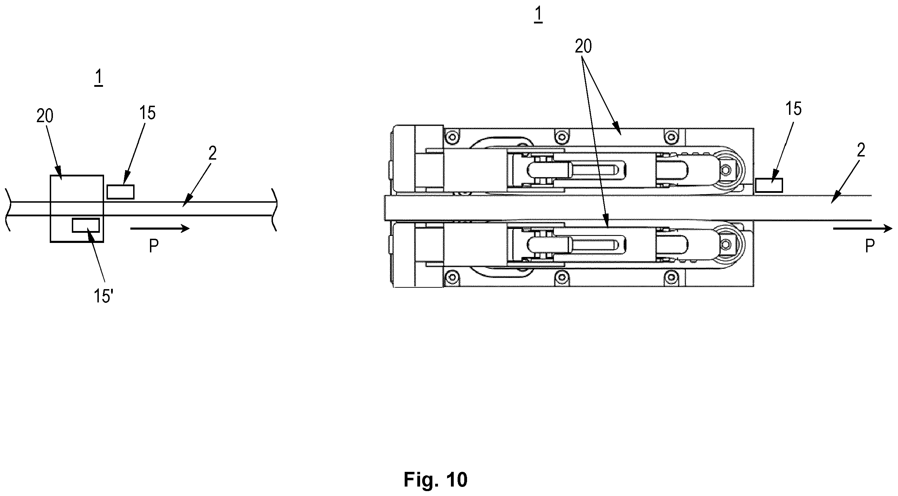

**Fig. 10** zeigt eine alternative Ausgestaltung des Vortriebssystem 1 zum Vorschub eines Kabels 2 eines Kanalinspektions- und/oder Wartungssystem. Das Kabel 2 kann auch hier ein Schiebeaal sein.

Das in Fig. 10 gezeigte Vortriebssystem 1 umfasst eine Vortriebseinrichtung 20 zum Vorschub des Kabels 2, das hier einen Riemenantrieb umfasst. Ferner umfasst das Vortriebssystem 1 einen Temperatursensor 15, 15', wobei der Temperatursensor 15, 15' im Bereich der Vortriebseinrichtung 20 oder in Vorschubrichtung (Pfeil P) des Kabels 2 nach der Vortriebseinrichtung 20 angeordnet ist.

Der Temperatursensor 15 ist vorzugsweise angepasst, eine Temperatur des Kabels 2 zu detektieren. Die Temperatur des Kabels bezeichnet hier die von außen bestimmbare Temperatur an der Oberfläche des Kabels 2, im Wesentlichen also die Temperatur des Kabelmantels bzw. des Mantels des Schiebeaals. Der Temperatursensor 15' ist vorzugsweise angepasst, eine Temperatur der Vortriebselemente, etwa der Riemen des Riemenantriebes zu detektieren.

Das Vortriebssystem 1 umfasst auch hier eine Auswerteeinrichtung 80 und eine Steuereinrichtung 90. Der Temperatursensor 15, 15' kann der Auswerteeinrichtung 80 die detektierte Temperatur des Kabels 2 bzw. der Vortriebselemente bereitstellen. Dabei sind die Auswerteeinrichtung 80 und die Steuereinrichtung 90 für den Austausch von Daten koppelbar bzw. gekoppelt. Ferner kann die Steuereinrichtung 90 den Vorschub des Kabels 2 durch die Vortriebseinrichtung 20 steuern. Die Auswerteeinrichtung 80 ist angepasst, zu prüfen, ob die detektierte Temperatur oberhalb oder unterhalb eines vorbestimmten Schwellenwertes T liegt. Die Steuereinrichtung ist ferner angepasst, den Vorschub des Kabels 2 durch die Vortriebseinrichtung 20 anzupassen, wenn die detektierte Temperatur den vorbestimmten Schwellenwert T überschreitet.

Der Temperatursensor 15, 15' kann die Temperatur berührungslos messen, beispielsweise über eine Infrarotmessung.

Vorzugsweise ist die Steuereinrichtung 90 auch hier angepasst, den Vorschub des Kabels 2 durch die Vortriebseinrichtung 20 so lange anzupassen, vorzugsweise stufenweise anzupassen, bis die detektierte Temperatur den vorbestimmten Schwellenwert T wieder unterschreitet.

Für eine Erkennung eines Schlupfes beim Vorschub eines Kabels 2 kann die gemessene Temperatur des Kabels 2 bzw. der Vorschubelemente Aufschluss über das Vorhandensein eines Schlupfes geben, da sich das Kabel 2 bzw. die Vorschubelemente im Falle eines Schlupfes zügig und auf hohe Temperaturen erhitzen können. Im Falle eines Schlupfes bewirkt eine Anpassung, insbesondere eine Verlangsamung des Vorschubs eine unmittelbare Reduzierung des Schlupfes und damit eine deutliche Reduzierung der Temperatur des Kabels bzw. der Vorschubelemente.

Das Verfahren kann so angepasst sein, dass bei einer Erkennung eines Schlupfes der Vorschub so lange angepasst wird, vorzugsweise stufenweise angepasst wird, bis die gemessene Temperatur den vorbestimmten Schwellenwert T wieder unterschreitet.

**Fig. 11** zeigt eine Ausgestaltung und deren Funktionsweise einer Messvorrichtung, die nicht unter dem Schutzbereich der vorliegenden Ansprüche liegt.

Die Ausgleichseinrichtung 30 der Messvorrichtung 1 umfasst auch in dieser Ausgestaltung eine Magnetaufnahme 40, die hier einen Arm 41 umfasst. Am freien Ende des Arms 41, das dem Kabel 2 zugewandt ist, ist ein Magnet 50 angeordnet, der drehbar um eine Drehachse DA gelagert ist. Der Arm 41 selbst ist gemäß dieser Ausgestaltung im Wesentlichen senkrecht zum Kabel 2 ausgerichtet und linear (in Pfeilrichtung P) bewegbar gelagert. Wie bei den vorstehend beschriebenen Ausgestaltungen der der Messvorrichtung 1 weist die Messvorrichtung 1 auch hier einen Magnetfeldsensor 60 auf, der beabstandet zum Magneten 50 angeordnet ist, derart, dass der Magnetfeldsensor 60 Drehungen des Magneten detektieren kann.

Die Magnetaufnahme 40 bzw. der Arm 41 wird mit einer Stellkraft F beaufschlagt, um den Arm 41 in Richtung des Kabels 2 zu bewegen und dadurch den Magneten 50 gegen das Kabel 2 zu drücken. Der Vektor der Stellkraft F steht also im Wesentlichen senkrecht zur Längsachse das Kabels 2. Für die Beaufschlagung der Magnetaufnahme 40 bzw. des Arms 41 mit der Stellkraft F kann ein Stellglied, beispielsweise ein Federelement vorgesehen sein.

Die auf die Magnetaufnahme 40 bzw. auf den Arm 41 wirkende Stellkraft bewirkt, dass der Magnet 50 einer radialen Bewegung des Kabels 2 folgt, sodass gewährleistet ist, dass der Magnet 50 immer auf dem Kabel aufliegt und das Kabel bei einem Vorschub unabhängig von einer radialen Bewegung den Magneten 50 dreht. Die in Fig. 11 als gestrichelte Linien dargestellten Einheiten zeigen ein radial bewegtes Kabel 2 und die der radialen Bewegung des Kabels gefolgte Ausgleichseinrichtung 30.

Gemäß sämtlicher der vorstehend beschriebenen Ausführungsformen ist die Ausgleichseinrichtung 30 so ausgestaltet, dass jedenfalls der Magnet 50 einer radialen Bewegung des Kabels 2 folgen kann, d.h. wenn sich das Kabel beim Vorschub nach rechts bewegt, dann folgt der Magnet dieser Bewegung und bewegt ebenfalls nach rechts, sodass der Magnet immer am Kabel anliegt.

### Bezugszeichen

- 1: Vortriebssystem
- 2: Kabel
- 10: Messvorrichtung
- 15, 15': Temperatursensor
- 20: Vortriebseinrichtung zum Vorschub des Kabels 2
- 30: Ausgleichseinrichtung
- 40: Magnetaufnahme (z.B. Schwenkeinrichtung mit Schwenkarm)
- 41: Arm oder Schwenkarm der Magnetaufnahme 40
- 50, 50': drehbar gelagerter Magnet
- 51: Gehäuse
- 52: drehbar gelagertes Element
- 60: Magnetfeldsensor
- 61: Unterdruck / Überdruck aufweisender Raum
- 70: Stellglied, z.B. Federelement
- 80: Auswerteeinrichtung
- 90: Steuereinrichtung
- A-A: Schnitt A-A
- B-B: Schnitt B-B
- DA, DA': Drehachse
- F: Stellkraft
- LA: Längsachse des Kabels 2 bzw. des Vortriebssystems 1
- M1: erster Messwert des Vorschubs des Kabels 2
- M2: zweiter Messwert des Vorschubs des Kabels 2
- P: Pfeil; Vorschubrichtung des Kabels 2
- SA: Schwenkachse
- T: Schwellenwert
- V: Anpassen (Verlangsamung / Beschleunigung) des Kabels 2
- ΔM: Differenz zwischen dem ersten Messwert M1 und dem zweiten Messwert M2

## Patentansprüche

1. Messvorrichtung (10) zum Messen eines Vorschubs eines Kabels (2) eines Kanalreinigungs- und/oder Kanalinspektionssystems, umfassend
- eine Ausgleichseinrichtung (30), umfassend
- zumindest einen um eine Drehachse (DA; DA') drehbar gelagerten Magneten (50; 50'), und
- eine Magnetaufnahme (40) zur Aufnahme des zumindest einen drehbar gelagerten Magneten (50; 50'), und
- einen Magnetfeldsensor (60),
wobei
- das Kabel (2) beim Vorschub des Kabels (2) an der Ausgleichseinrichtung (30) vorbeiführbar ist,
- der zumindest eine drehbar gelagerte Magnet (50; 50') derart an der Magnetaufnahme (40) angeordnet ist, dass durch den Vorschub des Kabels (2) Drehungen des zumindest einen drehbar gelagerten Magneten (50; 50') um die Drehachse (DA; DA') bewirkbar sind, wobei die Magnetaufnahme (40) der Ausgleichseinrichtung (30) angepasst ist, einer Bewegung des Kabels (2) in radialer Richtung während des Vorschubs zu folgen,
- der Magnetfeldsensor (60) beabstandet zum zumindest einen drehbar gelagerten Magneten (50; 50') stationär angeordnet ist und angepasst ist, die Drehungen des zumindest einen drehbar gelagerten Magneten (50; 50') zu detektieren, wobei die detektierten Drehungen ein Maß für den Vorschub des Kabels (2) sind,
- wobei die Magnetaufnahme (40) einen Schwenkarm (41) umfasst, und der zumindest eine drehbar gelagerte Magnet (50) an einem freien Ende des Schwenkarms (41) angeordnet ist, wodurch der zumindest eine drehbar gelagerte Magnet (50) relativ zum Magnetfeldsensor (60) schwenkbar ist.

2. Messvorrichtung nach Anspruch 1, wobei die Ausgleichseinrichtung (30) ein auf die Magnetaufnahme (40) wirkendes Stellglied (70), insbesondere Federelement, umfasst, wobei das Stellglied (70) ausgebildet ist,
- ein Schwenken der Magnetaufnahme (40) um eine Schwenkachse (SA) oder
- ein lineares Verschieben der Magnetaufnahme (40)
zu bewirken, wodurch die Magnetaufnahme (40) der radialen Bewegung des Kabels (2) folgt.

3. Messvorrichtung nach Anspruch 2, wobei das Stellglied (70) derart relativ zur Magnetaufnahme (40) angeordnet ist, dass eine Beaufschlagung der Magnetaufnahme (40) mit einer Stellkraft des Stellgliedes (70) den zumindest einen an der Magnetaufnahme (40) drehbar gelagerten Magneten (50; 50') an das vorbeigeführte Kabel (2) drückt.

4. Messvorrichtung nach einem der vorhergehenden Ansprüche, wobei der zumindest eine drehbar gelagerte Magnet (50; 50') in einem Gehäuse (51) angeordnet ist, wobei das Gehäuse (51) vorzugsweise eine drehsymmetrische Form, insbesondere zylindrische Form, aufweist.

5. Messvorrichtung nach einem der vorhergehenden Ansprüche 2 bis 4, wobei die Schwenkachse (SA) die Drehachse (DA') des zumindest einen drehbar gelagerten Magneten (50') bildet.

6. Messvorrichtung nach einem der vorhergehenden Ansprüche, ferner umfassend ein drehbar gelagertes Element (52), das derart an der Magnetaufnahme (40) angeordnet ist, dass durch den Vorschub des Kabels (2) Drehungen des drehbar gelagerten Elements (52) bewirkbar sind, wobei
- das drehbar gelagerte Element (52) mit dem zumindest einen drehbar gelagerten Magneten (50; 30') koppelbar ist, und
- die Drehungen des drehbar gelagerten Elements (52) durch die Kopplung mit dem zumindest einen drehbar gelagerten Magneten (50; 50') auf den zumindest einen drehbar gelagerten Magneten (50; 50') übertragbar sind, um den zumindest einen drehbar gelagerten Magneten (50; 50') zu drehen.

7. Messvorrichtung nach einem der vorhergehenden Ansprüche, wobei der Magnetfeldsensor (60) in einem einen Unterdruck oder einen Überdruck aufweisenden Raum (61) angeordnet ist.

8. Messvorrichtung nach einem der vorhergehenden Ansprüche, wobei das Kabel ein Schiebeaal ist.

9. System umfassend zwei Messvorrichtungen nach einem der vorhergehenden Ansprüche, wobei die zwei Messvorrichtungen auf unterschiedlichen Seiten des Kabels (2), vorzugsweise auf zwei gegenüberliegenden Seiten des Kabels (2), angeordnet sind und jeweils angepasst sind einen Messwert für einen Vorschub des Kabels (2) bezogen auf die jeweilige Messvorrichtung zu ermitteln, wobei aus den ermittelten Messwerten der Vorschub des Kabels (2) bezogen auf das System abgeleitet wird, vorzugsweise durch Bilden eines Mittelwertes aus den ermittelten Messwerten.

10. Verfahren zum Messen eines Vorschubs eines Kabels (2) eines Kanalreinigungs- und/oder Kanalinspektionssystems, wobei
- zumindest ein drehbar gelagerter Magnet (50; 50') derart relativ zum Kabel (2) angeordnet wird, dass ein Vorschub des Kabels (2) ein Drehen des zumindest einen drehbar gelagerten Magneten (50; 50') bewirkt,
- ein Magnetfeldsensor (60) derart relativ zum zumindest einen drehbar gelagerter Magneten (50; 50') angeordnet wird, dass mit ihm Drehungen des zumindest einen drehbar gelagerter Magneten (50; 50') detektierbar sind, wobei aus den detektierten Drehungen der Vorschub des Kabels (2) ermittelt wird,
- radiale Bewegungen des Kabels (2) während des Vorschubs des Kabels (2) ausgeglichen werden, indem der zumindest eine drehbar gelagerte Magnet (50; 50') den radialen Bewegungen des Kabels (2) folgt, damit auch bei einer radialen Bewegung des Kabels (2) während des Vorschubs des Kabels (2) das Drehen des zumindest einen drehbar gelagerten Magneten (50; 50') bewirkt wird, und
- zum Messen des Vorschubs des Kabels (2) zumindest eine Messvorrichtung (10) nach einem der vorhergehenden Ansprüche 1 bis 8 verwendet wird.

11. Verfahren nach dem vorhergehenden Anspruch, wobei das Kabel ein Schiebeaal ist.

## Claims

1. Measuring device (10) for measuring an advancement of a cable (2) of a sewer cleaning and/or sewer inspection system, comprising
- a compensation device (30), comprising
- at least one magnet (50; 50') mounted so as to be rotatable about an axis of rotation (DA; DA'), and
- a magnet holder (40) for receiving the at least one rotatably mounted magnet (50; 50'), and
- a magnetic field sensor (60),
wherein
- the cable (2) can be guided past the compensation device (30) while the cable (2) is being advanced,
- the at least one rotatably mounted magnet (50; 50') is arranged on the magnet holder (40) in such a way that the advancement of the cable (2) can cause rotations of the at least one rotatably mounted magnet (50; 50') about the axis of rotation (DA; DA'), wherein the magnet holder (40) of the compensation device (30) is adapted to follow a movement of the cable (2) in the radial direction during advancement,
- the magnetic field sensor (60) is arranged at a distance from the at least one rotatably mounted magnet (50; 50') and is adapted to detect the rotations of the at least one rotatably mounted magnet (50; 50'), wherein the detected rotations are a measure of the advancement of the cable (2),
- wherein the magnet holder (40) comprises a pivot arm (41), and the at least one rotatably mounted magnet (50) is arranged at a free end of the pivot arm (41), as a result of which the at least one rotatably mounted magnet (50) is pivotable relative to the magnetic field sensor (60).

2. Measuring device according to claim 1, wherein the compensation device (30) comprises an actuator (70), in particular a spring element, which acts on the magnet holder (40), wherein the actuator (70) is designed to cause
- a pivoting of the magnet holder (40) about a pivot axis (SA) or
- a linear displacement of the magnet holder (40),
as a result of which the magnet holder (40) follows the radial movement of the cable (2).

3. Measuring device according to claim 2, wherein the actuator (70) is arranged relative to the magnet holder (40) in such a way that applying an actuating force to the magnet holder (40) by means of the actuator (70) presses the at least one magnet (50; 50') rotatably mounted on the magnet holder (40) onto the cable (2) that is being guided past.

4. Measuring device according to any of the preceding claims, wherein the at least one rotatably mounted magnet (50; 50') is arranged in a housing (51), wherein the housing (51) preferably has a rotationally symmetrical shape, in particular a cylindrical shape.

5. Measuring device according to any of the preceding claims 2 to 4, wherein the pivot axis (SA) forms the axis of rotation (DA') of the at least one rotatably mounted magnet (50').

6. Measuring device according to any of the preceding claims, further comprising a rotatably mounted element (52) which is arranged on the magnet holder (40) in such a way that rotations of the rotatably mounted element (52) can be caused by the advancement of the cable (2), wherein
- the rotatably mounted element (52) can be coupled to the at least one rotatably mounted magnet (50; 30'), and
- the rotations of the rotatably mounted element (52) can be transmitted to the at least one rotatably mounted magnet (50; 50') by means of the coupling with the at least one rotatably mounted magnet (50; 50'), in order to rotate the at least one rotatably mounted magnet (50; 50').

7. Measuring device according to any of the preceding claims, wherein the magnetic field sensor (60) is arranged in a space (61) having a negative pressure or a positive pressure.

8. Measuring device according to any of the preceding claims, wherein the cable is a push rod.

9. System comprising two measuring devices according to any of the preceding claims, wherein the two measuring devices are arranged on different sides of the cable (2), preferably on two opposing sides of the cable (2), and are each adapted to determine a measured value for an advancement of the cable (2) in relation to the relevant measuring device, wherein the advancement of the cable (2) in relation to the system is derived from the determined measured values, preferably by forming an average value from the determined measured values.

10. Method for measuring an advancement of a cable (2) of a sewer cleaning and/or sewer inspection system, wherein
- at least one rotatably mounted magnet (50; 50') is arranged relative to the cable (2) in such a way that an advancement of the cable (2) causes a rotation of the at least one rotatably mounted magnet (50; 50'),
- a magnetic field sensor (60) is arranged relative to the at least one rotatably mounted magnet (50; 50') in such a way that rotations of the at least one rotatably mounted magnet (50; 50') can be detected therewith, wherein the advancement of the cable (2) is determined from the detected rotations,
- radial movements of the cable (2) during advancement of the cable (2) are compensated for by the at least one rotatably mounted magnet (50; 50') following the radial movements of the cable (2), such that the rotation of the at least one rotatably mounted magnet (50; 50') is caused even in the case of a radial movement of the cable (2) during advancement of the cable (2), and
- at least one measuring device (10) according to any of the preceding claims 1 to 8 is used to measure the advancement of the cable (2).

11. Method according to the preceding claim, wherein the cable is a push rod.

## Revendications

1. Dispositif de mesure (10) permettant de mesurer une avance d'un câble (2) d'un système de nettoyage et/ou d'inspection de canalisations, comprenant
- un appareil de compensation (30), comprenant
- au moins un aimant monté de manière à pouvoir tourner (50 ; 50') autour d'un axe de rotation (DA ; DA'), et
- un logement pour aimant (40) destiné à recevoir l'au moins un aimant monté de manière à pouvoir tourner (50 ; 50'), et
- un capteur de champ magnétique (60),
dans lequel
- le câble (2) peut passer devant l'appareil de compensation (30) lors de l'avance du câble (2),
- l'au moins un aimant monté de manière à pouvoir tourner (50 ; 50') est disposé sur le logement pour aimant (40) de telle sorte que des rotations de l'au moins un aimant monté de manière à pouvoir tourner (50 ; 50') peuvent être provoquées autour de l'axe de rotation (DA ; DA') par l'avance du câble (2), dans lequel le logement pour aimant (40) de l'appareil de compensation (30) est adapté pour suivre un mouvement du câble (2) dans la direction radiale pendant l'avance,
- le capteur de champ magnétique (60) est disposé de manière stationnaire à distance de l'au moins un aimant monté de manière à pouvoir tourner (50 ; 50') et est adapté pour détecter les rotations de l'au moins un aimant monté de manière à pouvoir tourner (50 ; 50'), dans lequel les rotations détectées sont une mesure de l'avance du câble (2),
- dans lequel le logement pour aimant (40) comprend un bras pivotant (41), et l'au moins un aimant monté de manière à pouvoir tourner (50) est disposé au niveau d'une extrémité libre du bras pivotant (41), moyennant quoi l'au moins un aimant monté de manière à pouvoir tourner (50) peut pivoter par rapport au capteur de champ magnétique (60).

2. Dispositif de mesure selon la revendication 1, dans lequel l'appareil de compensation (30) comprend un actionneur (70), en particulier un élément formant ressort, agissant sur le logement pour aimant (40), dans lequel l'actionneur (70) est conçu pour provoquer
- un pivotement du logement pour aimant (40) autour d'un axe de pivotement (SA) ou
- un déplacement linéaire du logement pour aimant (40),
moyennant quoi le logement pour aimant (40) suit le mouvement radial du câble (2).

3. Dispositif de mesure selon la revendication 2, dans lequel l'actionneur (70) est disposé par rapport au logement pour aimant (40) de telle sorte qu'une sollicitation du logement pour aimant (40) par une force d'actionnement de l'actionneur (70) pousse l'au moins un aimant monté de manière à pouvoir tourner (50 ; 50') sur le logement pour aimant (40) contre le câble (2) qui passe devant celui-ci.

4. Dispositif de mesure selon l'une des revendications précédentes, dans lequel l'au moins un aimant monté de manière à pouvoir tourner (50 ; 50') est disposé dans un boîtier (51), dans lequel le boîtier (51) présente de préférence une forme à symétrie de rotation, en particulier une forme cylindrique.

5. Dispositif de mesure selon l'une des revendications précédentes 2 à 4, dans lequel l'axe de pivotement (SA) forme l'axe de rotation (DA') de l'au moins un aimant monté de manière à pouvoir tourner (50').

6. Dispositif de mesure selon l'une des revendications précédentes, comprenant en outre un élément monté de manière à pouvoir tourner (52) qui est disposé sur le logement pour aimant (40) de telle sorte que des rotations de l'élément monté de manière à pouvoir tourner (52) peuvent être provoquées par l'avance du câble (2), dans lequel
- l'élément monté de manière à pouvoir tourner (52) peut être accouplé à l'au moins un aimant monté de manière à pouvoir tourner (50 ; 30'), et
- les rotations de l'élément monté de manière à pouvoir tourner (52) peuvent être transmises à l'au moins un aimant monté de manière à pouvoir tourner (50 ; 50') par l'accouplement avec l'au moins un aimant monté de manière à pouvoir tourner (50 ; 50') afin de faire tourner l'au moins un aimant monté de manière à pouvoir tourner (50 ; 50').

7. Dispositif de mesure selon l'une des revendications précédentes, dans lequel le capteur de champ magnétique (60) est disposé dans un espace (61) présentant une dépression ou une surpression.

8. Dispositif de mesure selon l'une des revendications précédentes, dans lequel le câble est une aiguille de tirage.

9. Système comprenant deux dispositifs de mesure selon l'une des revendications précédentes, dans lequel les deux dispositifs de mesure sont disposés sur des côtés différents du câble (2), de préférence sur deux côtés opposés du câble (2), et sont respectivement adaptés pour déterminer une valeur de mesure pour une avance du câble (2) par rapport au dispositif de mesure respectif, dans lequel l'avance du câble (2) par rapport au système est déduite des valeurs de mesure déterminées, de préférence par formation d'une valeur moyenne à partir des valeurs de mesure déterminées.

10. Procédé permettant de mesurer une avance d'un câble (2) d'un système de nettoyage et/ou d'inspection de canalisations, dans lequel
- au moins un aimant monté de manière à pouvoir tourner (50 ; 50') est disposé par rapport au câble (2) de telle sorte qu'une avance du câble (2) provoque une rotation de l'au moins un aimant monté de manière à pouvoir tourner (50 ; 50'),
- un capteur de champ magnétique (60) est disposé par rapport à l'au moins un aimant monté de manière à pouvoir tourner (50 ; 50') de telle sorte que des rotations de l'au moins un aimant monté de manière à pouvoir tourner (50 ; 50') peuvent être détectées par le capteur de champ magnétique, dans lequel l'avance du câble (2) est déterminée à partir des rotations détectées,
- des mouvements radiaux du câble (2) sont compensés pendant l'avance du câble (2) du fait que l'au moins un aimant monté de manière à pouvoir tourner (50 ; 50') suit les mouvements radiaux du câble (2), de sorte que la rotation de l'au moins un aimant monté de manière à pouvoir tourner (50 ; 50') est également provoquée lors d'un mouvement radial du câble (2) pendant l'avance du câble (2), et
- au moins un dispositif de mesure (10) selon l'une des revendications précédentes 1 à 8 est utilisé pour la mesure de l'avance du câble (2).

11. Procédé selon la revendication précédente, dans lequel le câble est une aiguille de tirage.
